# EUROPEAN PATENT APPLICATION

(11) **EP 4 646 054 A1**
(43) Date of publication of application: **05.11.2025**
(21) Application number: 25172896.0
(22) Date of filing: 28.04.2025
(51) Int. Cl.: H10D 30/65, H10D 30/66, H10D 62/10, H10D 30/60

(54) **SEMICONDUCTOR DEVICES WITH INCREASED BREAKDOWN VOLTAGE CHARACTERISTICS**

(30) Priority: 29.04.2024 US 202418649407
(71) Applicant: Avago Technologies International Sales Pte. Limited, Singapore 768923 (SG)
(72) Inventor: Ito, Akira, Irvine, 92618 (US)
(74) Representative: Dilg, Haeusler, Schindelmann Patentanwaltsgesellschaft mbH

(57) **Abstract**

Semiconductor devices (100, 200, 300) with increased breakdown voltage characteristics for use in a variety of suitable applications. An example semiconductor device (100, 200, 300) having increased breakdown voltage characteristics includes a substrate (110, 210, 310) having a p-type well (142, 144, 242, 244, 342, 344, 346), an n-type well (122, 124, 126, 222, 224, 226, 322, 324), an n-type layer (121, 123, 125, 221, 223, 225, 321, 323), and a depletion region (152, 154, 252, 254, 352, 354) and a gate (172, 174, 272, 274, 372, 374) disposed over the p-type well (142, 144, 242, 244, 342, 344, 346), the depletion region (152, 154, 252, 254, 352, 354), and the n-type layer (121, 123, 125, 221, 223, 225, 321, 323). The depletion region (152, 154, 252, 254, 352, 354) and the n-type layer (121, 123, 125, 221, 223, 225, 321, 323) are disposed between the p-type well (142, 144, 242, 244, 342, 344, 346) and the n-type well (122, 124, 126, 222, 224, 226, 322, 324) and the depletion region (152, 154, 252, 254, 352, 354) is disposed between the p-type well (142, 144, 242, 244, 342, 344, 346) and the n-type layer (121, 123, 125, 221, 223, 225, 321, 323).

## Description

### BACKGROUND

The present disclosure relates, in general, to semiconductor fabrication technology. More particularly, the present disclosure relates to semiconductor device structures that can be used to provide increased breakdown voltage characteristics in various applications. For example, the semiconductor device structures described herein can be used in implementations of laterally diffused metal-oxide-semiconductors (LDMOS) for use in a variety of different high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

### BRIEF DESCRIPTION OF THE DRAWINGS

FIG. 1 shows a cross section illustrating example components of a semiconductor device, in accordance with some aspects of the disclosure.
FIG. 2 shows a cross section illustrating example components of another semiconductor device, in accordance with some aspects of the disclosure.
FIG. 3 shows a cross section illustrating example components of a further semiconductor device, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

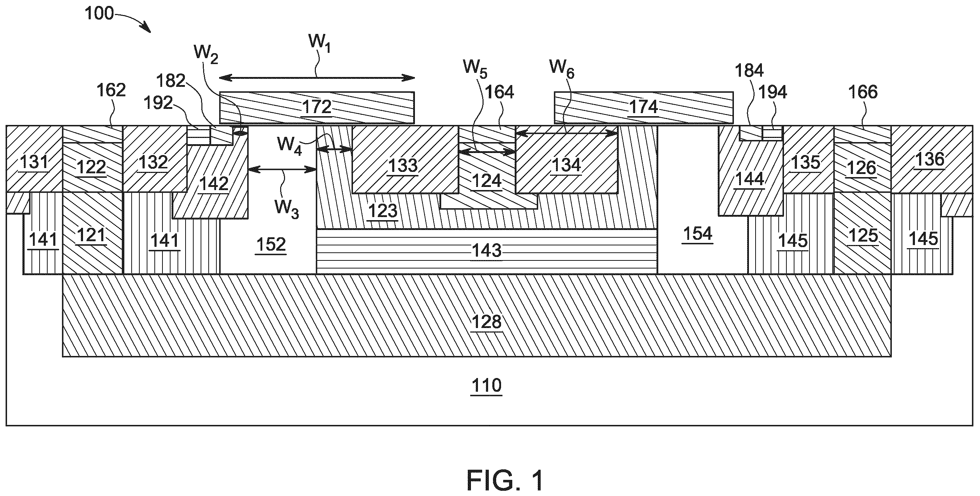

Referring to FIG. 1, a cross section illustrating example components of a semiconductor device 100 is shown, in accordance with some aspects of the disclosure. The semiconductor device 100 can be implemented as a variety of types of semiconductor devices, such as, for example, various types and combinations of transistor device structures. For example, the semiconductor device 100 can include an LDMOS device. As shown in FIG. 1, the semiconductor device 100 includes a substrate 110, an n-type well 122, an n-type well 124, an n-type well 126, a deep n-type well (DNW) (or N+ buried layer (NBL)) 128, an n-type layer 121, an n-type layer 123, an n-type layer 125, an isolation structure 131, an isolation structure 132, an isolation structure 133, an isolation structure 134, an isolation structure 135, an isolation structure 136, a p-type well 142, a p-type well 144, a p-type layer 141, a p-type layer 143, a p-type layer 145, a depletion region 152, a depletion region 154, a drain 162, a drain 164, a drain 166, a gate 172, a gate 174, a source 182, a source 184, a body 192, and a body 194. A variety of widths W₁-W₆ associated with the example semiconductor device 100 are also shown in FIG. 1.

The substrate 110 may comprise silicon material (e.g., crystalline silicon) and/or other suitable materials or combinations of materials. The depletion region 152 and the depletion region 154 can be defined by the substrate 110. The substrate 110 can be formed using various fabrication technologies, such as using a silicon-on-insulator (SOI) structure, a bulk semiconductor structure, an alloy semiconductor, a compound semiconductor, germanium, and/or various other suitable materials and combinations thereof. The substrate 110 can provide a base for forming components of the semiconductor device 100 thereon. The semiconductor device 100 can be implemented in a variety of different types of circuits, inducing various types of integrated circuit (IC) chips. The substrate 110 can be lightly doped using suitable p-type dopants, such as boron and/or other similar p-type dopants. The deep n-type well 128 can be formed within the substrate 110 to provide noise suppression within the substrate 110. The deep n-type well 128 can be formed by doping the substate 110 using any suitable n-type dopants such as arsenic, phosphorous, and/or other similar n-type dopants.

The n-type well 122, the n-type well 124, and the n-type well 126 generally are regions of the substrate 110 that are doped using n-type dopants such as arsenic, phosphorous, and/or other similar n-type dopants. The n-type well 122, the n-type well 124, and the n-type well 126 can include transistor terminals formed therein. Specifically, as shown in FIG. 1, the drain 162 can be formed in the n-type well 122, the drain 164 can be formed in the n-type well 124, and the drain 166 can be formed in the n-type well 126. The p-type well 142 and the p-type well 144 similarly are regions of the substrate 110 that are doped using p-type dopants, such as boron and/or other similar p-type dopants. The p-type well 142 and the p-type well 144 can also include transistor terminals formed therein. Specifically, as shown in FIG. 1, the source 182 can be formed in the p-type well 142, and the source 184 can be formed in the p-type well 144.

The n-type layer 121, the n-type layer 123, and the n-type layer 125 are layers of the substrate 110 that are doped using n-type dopants such as arsenic, phosphorous, and/or other similar n-type dopants, but do not include transistor terminal formed therein. The p-type layer 141, a p-type layer 143, a p-type layer 145 similarly are layers of the substrate 110 that are doped using p-type dopants, such as boron and/or other similar p-type dopants, but also do not include transistor terminal formed therein. The transistor terminals including the drain 162, the drain 164, the drain 166, the source 182, and the source 184 can be formed within the n-type well 122, the n-type well 124, the n-type well 126, the p-type well 142, and the p-type well 144, respectively, using various suitable processes and materials. For example, the drain 162, the drain 164, the drain 166, the source 182, and the source 184 can be formed within the n-type well 122, the n-type well 124, the n-type well 126, the p-type well 142, and the p-type well 144, respectively, using various epitaxy processes and epitaxial materials (e.g., silicon, gallium arsenide, etc.). Notably, as shown in FIG. 1, the n-type layer 123 is disposed at least partially under the n-type well 124, the p-type layer 143 is disposed at least partially under the n-type layer 123, and the p-type layer 141 is disposed at least partially under the p-type well 142. The positioning of these layers relative to each other can help facilitate proper operation of the semiconductor device 100 with increased breakdown voltage characteristics.

The isolation structure 131, the isolation structure 132, the isolation structure 133, the isolation structure 134, the isolation structure 135, and the isolation structure 136 can be shallow trench isolation (STI) structures, for example, among other possible types of dielectric layers. The isolation structure 131, the isolation structure 132, the isolation structure 133, the isolation structure 134, the isolation structure 135, and the isolation structure 136 can be formed as a result of etching trenches in the semiconductor device 100. For example, after etching the n-type layer 123, the isolation structure 133 and the isolation structure 134 can be formed by depositing a dielectric material in one or more resulting trenches. The dielectric material used to form the isolation structure 131, the isolation structure 132, the isolation structure 133, the isolation structure 134, the isolation structure 135, and the isolation structure 136 can be, for example, silicon oxide, silicon nitride, and/or other suitable materials and combinations of materials. The isolation structure 131, the isolation structure 132, the isolation structure 133, the isolation structure 134, the isolation structure 135, and the isolation structure 136 can prevent leakage of electric current between different components of the semiconductor device 100.

The depletion region 152 and the depletion region 154 generally are insulating regions of the substrate 110, where mobile charge carriers have been diffused away and/or forced away by an electric field. The ionized donor and/or acceptor impurities left in the depletion region 152 and the depletion region 154 result in a depletion of charge carriers within the depletion region 152 and the depletion region 154, thereby limiting the amount of current that can flow through the depletion region 152 and the depletion region 154. Like the substrate 110, the depletion region 152 and the depletion region 154 can be lightly doped using suitable p-type dopants, such as boron and/or other similar p-type dopants. Relative to alternative device structures that do not include the depletion region 152 and/or the depletion region 154, the presence of the depletion region 152 and the depletion region 154 in the semiconductor device 100 can increase the breakdown voltage of the semiconductor device 100. For example, in some applications, the presence of the depletion region 152 and the depletion region 154 in the semiconductor device 100 can increase the breakdown voltage of the semiconductor device 100 by about 3-6 volts. This increased breakdown voltage of the semiconductor device 100 can provide advantages in various applications such as, for example, wireless charging applications (e.g., circuits used in wireless chargers for personal electronic devices, etc.). The presence of the depletion region 152 and the depletion region 154 in the semiconductor device 100 can also increase the on-resistance (Rₒₙ) of the semiconductor device 100 in some applications.

The gate 172 and the gate 174 can be formed using polysilicon material and/or another suitable material or combination of materials (e.g., a metal gate). Voltage applied at the gate 172 and/or the gate 174 can generally control the operation and conductance of the semiconductor device 100. In some examples, spacers can be formed at least partially around the gate 172 and/or the gate 174 to electrically isolate the gate 172 and/or the gate 174 and prevent charge leakage. The spacers can be formed using materials with high dielectric constants such as silicon nitride, silicon oxide, and/or other suitable materials and combinations thereof. Additionally, a gate oxide layer can be formed between the gate 172 and/or the gate 174 and the underlying regions of the substrate 110 using materials such as silicon nitride, aluminum oxide, silicon dioxide, and/or other suitable materials and combinations thereof.

The width W₁ as shown in FIG. 1 represents the width of the gate 172 as measured from the perspective shown in the cross section of the semiconductor device 100 as illustrated in FIG. 1. The width W₁ can be between 900 nanometers (nm) and 2,100 nanometers in some examples. The width W₂ as shown in FIG. 1 represents the width of the p-type well 142 as measured between the source 182 and the depletion region 152. The width W₂ can be between 50 and 350 nanometers in some examples. The width W₃ as shown in FIG. 1 represents the width of the depletion region 152 as measured between the p-type well 142 and the n-type layer 123. The width W₃ can be between 250 and 1,100 nanometers in some examples. The width W₄ as shown in FIG. 1 represents the width of the n-type layer 123 as measured between the depletion region 152 and the isolation structure 133 (e.g., dielectric layer). The width W₄ can also be between 250 and 1,100 nanometers in some examples. The width W₅ as shown in FIG. 1 represents the width of the n-type well 124 as measured between the isolation structure 133 and the isolation structure 134. The width W₅ can be between 400 and 600 nanometers in some examples. Similarly, the width of the p-type well 142 when measured between the isolation structure 132 and the depletion region 152 can also be between 400 and 600 nanometers in some examples. The width W₆ that is shown in FIG. 1 represents the width of the isolation structure 134 as measured between the n-type well 124 and the n-type layer 123. The width W₆ (also the width of the isolation structure 133) can be between 250 and 1500 nanometers in some examples. These specific dimensions can provide advantages in terms of facilitating proper operation of the semiconductor device 100 with increased breakdown voltage characteristics.

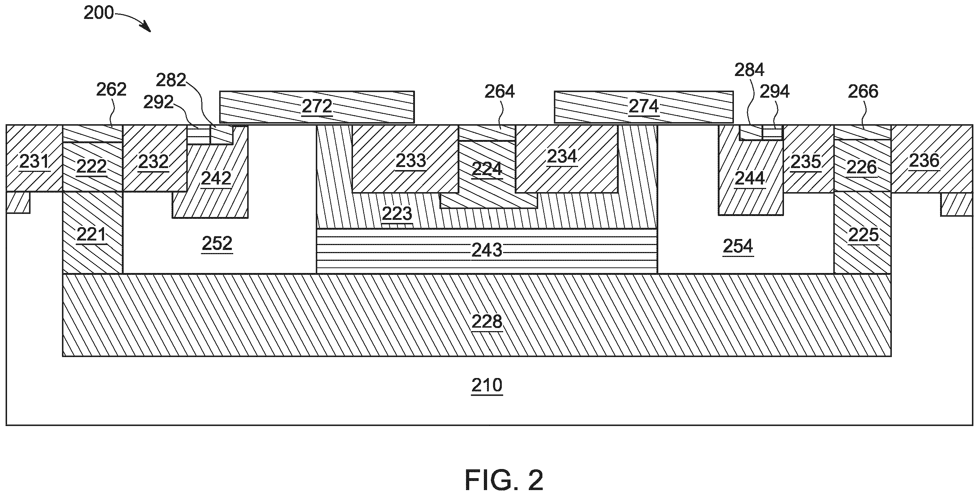

Referring to FIG. 2, a cross section illustrating example components of a semiconductor device 200 is shown, in accordance with some aspects of the disclosure. The semiconductor device 200 can be implemented as a variety of types of semiconductor devices, such as, for example, various types and combinations of transistor device structures. For example, the semiconductor device 200 can include an LDMOS device. The semiconductor device 200 can be similar to the semiconductor device 100 and can provide similar advantages in terms of operating with increased breakdown voltage characteristics. However, in comparison to the semiconductor device 100, the semiconductor device 200 does not include p-type layers disposed under the p-type wells and sources like the p-type layer 141 and the p-type layer 145 of the semiconductor device 100. These p-type layers can be removed in certain applications to provide even higher isolation breakdown characteristics (and thereby additional breakdown voltage increases) relative to the semiconductor device 100. As shown in FIG. 2, the semiconductor device 200 includes a substrate 210, an n-type well 222, an n-type well 224, an n-type well 226, a deep n-type well 228, an n-type layer 221, an n-type layer 223, an n-type layer 225, an isolation structure 231, an isolation structure 232, an isolation structure 233, an isolation structure 234, an isolation structure 235, an isolation structure 236, a p-type well 242, a p-type well 244, a p-type layer 243, a depletion region 252, a depletion region 254, a drain 262, a drain 264, a drain 266, a gate 272, a gate 274, a source 282, a source 284, a body 292, and a body 294.

The substrate 210 may comprise silicon material (e.g., crystalline silicon) and/or other suitable materials or combinations of materials. The depletion region 252 and the depletion region 254 can be defined by the substrate 210. The substrate 210 can be formed using various fabrication technologies, such as using a silicon-on-insulator structure, a bulk semiconductor structure, an alloy semiconductor, a compound semiconductor, germanium, and/or other suitable materials and combinations thereof. The substrate 210 cam provide a base for forming components of the semiconductor device 200 thereon. The semiconductor device 200 can be implemented in a variety of different types of circuits, inducing various types of integrated circuit chips. The substrate 210 can be lightly doped using suitable p-type dopants, such as, for example, boron and/or other similar p-type dopants. The deep n-type well 228 can be formed within the substrate 210 to provide noise suppression within the substrate 210. The deep n-type well 228 can be formed by doping the substate 210 using any suitable n-type dopants such as arsenic, phosphorous, and/or other similar n-type dopants.

The n-type well 222, the n-type well 224, and the n-type well 226 generally are regions of the substrate 210 that are doped using n-type dopants such as arsenic, phosphorous, and/or other similar n-type dopants. The n-type well 222, the n-type well 224, and the n-type well 226 can include transistor terminals formed therein. Specifically, as shown in FIG. 2, the drain 262 can be formed in the n-type well 222, the drain 264 can be formed in the n-type well 224, and the drain 266 can be formed in the n-type well 226. The p-type well 242 and the p-type well 244 similarly are regions of the substrate 210 that are doped using p-type dopants, such as boron and/or other similar p-type dopants. The p-type well 242 and the p-type well 244 can also include transistor terminals formed therein. Specifically, as shown in FIG. 2, the source 282 can be formed in the p-type well 242, and the source 284 can be formed in the p-type well 244.

The n-type layer 221, the n-type layer 223, and the n-type layer 225 are layers of the substrate 210 that are doped using n-type dopants such as arsenic, phosphorous, and/or other similar n-type dopants, but do not include transistor terminal formed therein. The p-type layer 243 similarly is a layer of the substrate 210 that is doped using p-type dopants, such as boron and/or other similar p-type dopants, but also does not include transistor terminal formed therein. The transistor terminals including the drain 262, the drain 264, the drain 266, the source 282, and the source 284 can be formed within the n-type well 222, the n-type well 224, the n-type well 226, the p-type well 242, and the p-type well 244, respectively, using various suitable processes and materials. For example, the drain 262, the drain 264, the drain 266, the source 282, and the source 284 can be formed within the n-type well 222, the n-type well 224, the n-type well 226, the p-type well 242, and the p-type well 244, respectively, using various epitaxy processes and epitaxial materials (e.g., silicon, gallium arsenide, etc.). Notably, as shown in FIG. 2, the n-type layer 223 is disposed at least partially under the n-type well 224 and the p-type layer 243 is disposed at least partially under the n-type layer 223. The positioning of these layers relative to each other can help facilitate proper operation of the semiconductor device 200 with increased breakdown voltage characteristics.

The isolation structure 231, the isolation structure 232, the isolation structure 233, the isolation structure 234, the isolation structure 235, and the isolation structure 236 can be shallow trench isolation structures, for example, among other possible types of dielectric layers. The isolation structure 231, the isolation structure 232, the isolation structure 233, the isolation structure 234, the isolation structure 235, and the isolation structure 236 can be formed as a result of etching trenches in the semiconductor device 200. For example, after etching the n-type layer 223, the isolation structure 233 and the isolation structure 234 can be formed by depositing a dielectric material in one or more resulting trenches. The dielectric material used to form the isolation structure 231, the isolation structure 232, the isolation structure 233, the isolation structure 234, the isolation structure 235, and the isolation structure 236 can be, for example, silicon oxide, silicon nitride, and/or other suitable materials and combinations of materials. The isolation structure 231, the isolation structure 232, the isolation structure 233, the isolation structure 234, the isolation structure 235, and the isolation structure 236 can prevent leakage of electric current between different components of the semiconductor device 200.

The depletion region 252 and the depletion region 254 generally are insulating regions of the substrate 210, where mobile charge carriers have been diffused away and/or forced away by an electric field. The ionized donor and/or acceptor impurities left in the depletion region 252 and the depletion region 254 result in a depletion of charge carriers within the depletion region 252 and the depletion region 254, thereby limiting the amount of current that can flow through the depletion region 252 and the depletion region 254. Like the substrate 210, the depletion region 252 and the depletion region 254 can be lightly doped using suitable p-type dopants, such as boron and/or other similar p-type dopants. Relative to alternative device structures that do not include the depletion region 252 and/or the depletion region 254, the presence of the depletion region 252 and the depletion region 254 in the semiconductor device 200 can increase the breakdown voltage of the semiconductor device 200. For example, in some applications, the presence of the depletion region 252 and the depletion region 254 within the semiconductor device 200 can increase the breakdown voltage of the semiconductor device 200 by about 3-6 volts. This increased breakdown voltage of the semiconductor device 200 can provide advantages in various applications such as, for example, wireless charging applications (e.g., circuits used in wireless chargers for personal electronic devices, etc.). The presence of the depletion region 252 and the depletion region 254 in the semiconductor device 200 can also increase the on-resistance of the semiconductor device 200 in some applications.

The gate 272 and the gate 274 can be formed using polysilicon material and/or another suitable material or combination of materials (e.g., a metal gate). Voltage applied at the gate 272 and/or the gate 274 can generally control the operation and conductance of the semiconductor device 200. In some examples, spacers can be formed at least partially around the gate 272 and/or the gate 274 to electrically isolate the gate 272 and/or the gate 274 and prevent charge leakage. The spacers can be formed using materials with high dielectric constants such as silicon nitride, silicon oxide, and/or other suitable materials and combinations thereof. Additionally, a gate oxide layer can be formed between the gate 272 and/or the gate 274 and the underlying regions of the substrate 210 using materials such as silicon nitride, aluminum oxide, silicon dioxide, and/or other suitable materials and combinations thereof.

The dimensional characteristics of the components of the semiconductor device 200 can be similar to those discussed above with respect to the semiconductor device 100. For example, a width of the gate 272 as measured from the perspective of the cross section of the semiconductor device 200 as illustrated in FIG. 2 can be between 900 nanometers and 2,100 nanometers in some examples. A width of the p-type well 242 as measured between the source 282 and the depletion region 252 can be between 50 and 350 nanometers in some examples. A width of the depletion region 252 as measured between the p-type well 242 and the n-type layer 223 can be between 250 and 1,100 nanometers in some examples. A width of the n-type layer 223 as measured between the depletion region 252 and the isolation structure 233 (e.g., dielectric layer) can also be between 250 and 1,100 nanometers in some examples. A width of the n-type well 224 as measured between the isolation structure 233 and the isolation structure 234 can be between 400 and 600 nanometers in some examples. Similarly, the width of the p-type well 242 when measured between the isolation structure 232 and the depletion region 252 can also be between 400 and 600 nanometers in some examples. A width of the isolation structure 234 (and the isolation structure 233) as measured between the n-type well 224 and the n-type layer 223 can be between 250 and 1500 nanometers in some examples. These specific dimensions can provide advantages in terms of facilitating proper operation of the semiconductor device 200 with increased breakdown voltage characteristics.

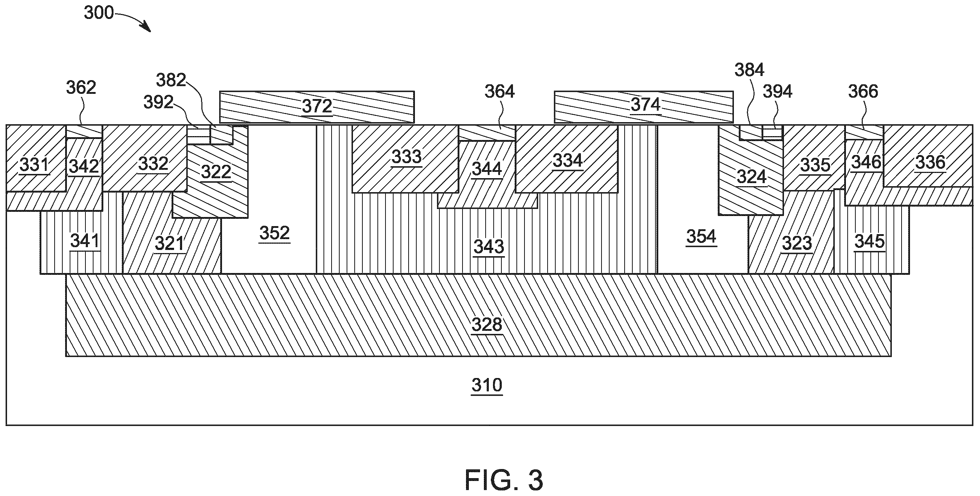

Referring to FIG 3, a cross section illustrating example components of another example semiconductor device 300 is shown, in accordance with some aspects of the disclosure. The semiconductor device 300 can be implemented as a variety of types of semiconductor devices, such as, for example, various types and combinations of transistor device structures. For example, the semiconductor device 300 can include an PLDMOS device. The semiconductor device 300 can be similar to the semiconductor device 100 and the semiconductor device 200 and can provide similar advantages in terms of operating with increased breakdown voltage characteristics. However, relative to the semiconductor device 100 and the semiconductor device 200, the doping polarities generally are reversed in the semiconductor device 300. The reversing of polarities as reflected in the structure of the semiconductor device 300 shown in FIG. 3 can provide advantages in various applications. As shown in FIG. 3, the semiconductor device 300 includes a substrate 310, an n-type well 322, an n-type well 324, a deep n-type well 328, an n-type layer 321, an n-type layer 323, an isolation structure 331, an isolation structure 332, an isolation structure 333, an isolation structure 334, an isolation structure 335, an isolation structure 336, a p-type well 342, a p-type well 344, a p-type well 346, a p-type layer 341, a p-type layer 343, a p-type layer 345, a depletion region 352, a depletion region 354, a drain 362, a drain 364, a drain 366, a gate 372, a gate 374, a source 382, a source 384, a body 392, and a body 394.

The substrate 310 may comprise silicon material (e.g., crystalline silicon) and/or other suitable materials or combinations of materials. The depletion region 352 and the depletion region 354 can be defined by the substrate 310. The substrate 310 can be formed using various fabrication technologies, such as using a silicon-on-insulator structure, a bulk semiconductor structure, an alloy semiconductor, a compound semiconductor, germanium, and/or other suitable materials and combinations thereof. The substrate 310 cam provide a base for forming components of the semiconductor device 300 thereon. The semiconductor device 300 can be implemented in a variety of different types of circuits, inducing various types of integrated circuit chips. The substrate 310 can be lightly doped using suitable p-type dopants, such as boron and/or other similar p-type dopants The deep n-type well 328 can be formed within the substrate 310 to provide noise suppression within the substrate 310. The deep n-type well 328 can be formed by doping the substate 310 using any suitable n-type dopants such as arsenic, phosphorous, and/or other similar n-type dopants.

The n-type well 322 and the n-type well 324 generally are regions of the substrate 310 that are doped using n-type dopants such as arsenic, phosphorous, and/or other similar n-type dopants. The n-type well 322 and the n-type well 324 can include transistor terminals formed therein. Specifically, as shown in FIG. 3, the source 382 can be formed in the n-type well 322 and the source 384 can be formed in the n-type well 324. The p-type well 342, the p-type well 344, and the p-type well 346 similarly are regions of the substrate 310 that are doped using p-type dopants, such as boron and/or other similar p-type dopants. The p-type well 342, the p-type well 344, and the p-type well 346 can also include transistor terminals formed therein. Specifically, as shown in FIG. 3, the drain 362 can be formed in the p-type well 342, the drain 364 can be formed in the p-type well 344, and the drain 366 can be formed in the p-type well 346.

The n-type layer 321 and the n-type layer 323 are layers of the substrate 310 that are doped using n-type dopants such as arsenic, phosphorous, and/or other similar n-type dopants, but do not include transistor terminal formed therein. The p-type layer 341, the p-type layer 343, and the p-type layer 345 similarly are layers of the substrate 310 that are doped using p-type dopants, such as boron and/or other similar p-type dopants, but also do not include transistor terminal formed therein. The transistor terminals including the drain 362, the drain 364, the drain 366, the source 382, and the source 384 can be formed within the n-type well 322, the n-type well 324, the p-type well 342, the p-type well 344, and the p-type well 346, respectively, using various suitable processes and materials. For example, the drain 362, the drain 364, the drain 366, the source 382, and the source 384 can be formed within the n-type well 322, the n-type well 324, the p-type well 342, the p-type well 344, and the p-type well 346, respectively, using various epitaxy processes and epitaxial materials (e.g., silicon, gallium arsenide, etc.). The n-type layer 321 and the n-type layer 323 can be removed from the semiconductor device 300 in certain applications to provide even higher isolation breakdown characteristics (and additional breakdown voltage increases). Notably, as shown in FIG. 3, the p-type layer 323 is disposed at least partially under the p-type well 344, and the n-type layer 321 is disposed at least partially under the n-type well 322. The positioning of these layers relative to each other can help facilitate proper operation of the semiconductor device 300 with increased breakdown voltage characteristics.

The isolation structure 331, the isolation structure 332, the isolation structure 333, the isolation structure 334, the isolation structure 335, and the isolation structure 336 can be shallow trench isolation structures, for example, among other possible types of dielectric layers. The isolation structure 331, the isolation structure 332, the isolation structure 333, the isolation structure 334, the isolation structure 335, and the isolation structure 336 can be formed as a result of etching trenches in the semiconductor device 300. For example, after etching the p-type layer 343, the isolation structure 333 and the isolation structure 334 can be formed by depositing a dielectric material in one or more resulting trenches. The dielectric material used to form the isolation structure 331, the isolation structure 332, the isolation structure 333, the isolation structure 334, the isolation structure 335, and the isolation structure 336 can be, for example, silicon oxide, silicon nitride, and/or other suitable materials and combinations of materials. The isolation structure 331, the isolation structure 332, the isolation structure 333, the isolation structure 334, the isolation structure 335, and the isolation structure 336 can prevent leakage of electric current between different components of the semiconductor device 300.

The depletion region 352 and the depletion region 354 generally are insulating regions of the substrate 310, where mobile charge carriers have been diffused away and/or forced away by an electric field. The ionized donor and/or acceptor impurities left in the depletion region 352 and the depletion region 354 result in a depletion of charge carriers within the depletion region 352 and the depletion region 354, thereby limiting the amount of current that can flow through the depletion region 352 and the depletion region 354. Like the substrate 310, the depletion region 352 and the depletion region 354 can be lightly doped using suitable p-type dopants, such as boron and/or other similar p-type dopants. Relative to alternative device structures that do not include the depletion region 352 and/or the depletion region 354, the presence of the depletion region 352 and the depletion region 354 in the semiconductor device 100 can increase the breakdown voltage of the semiconductor device 300. For example, in some applications, the presence of the depletion region 352 and the depletion region 354 within the semiconductor device 300 can increase the breakdown voltage of the semiconductor device 300 by about 3-6 volts. This increased breakdown voltage of the semiconductor device 300 can provide advantages in various applications such as, for example, wireless charging applications (e.g., circuits used in wireless chargers for personal electronic devices, etc.). The presence of the depletion region 352 and the depletion region 354 in the semiconductor device 300 can also increase the on-resistance of the semiconductor device 300 in some applications.

The gate 372 and the gate 374 can be formed using polysilicon material and/or another suitable material or combination of materials (e.g., a metal gate). Voltage applied at the gate 372 and/or the gate 374 can generally control the operation and conductance of the semiconductor device 300. In some examples, spacers can be formed at least partially around the gate 372 and/or the gate 374 to electrically isolate the gate 372 and/or the gate 374 and prevent charge leakage. The spacers can be formed using materials with high dielectric constants such as silicon nitride, silicon oxide, and/or other suitable materials and combinations thereof. Additionally, a gate oxide layer can be formed between the gate 372 and/or the gate 374 and the underlying regions of the substrate 310 using materials such as silicon nitride, aluminum oxide, silicon dioxide, and/or other suitable materials and combinations thereof.

The dimensional characteristics of the components of the semiconductor device 300 can be similar to those discussed above with respect to the semiconductor device 100. For example, a width of the gate 372 as measured from the perspective of the cross section of the semiconductor device 300 as illustrated in FIG. 3 can be between 900 nanometers and 2,100 nanometers in some examples. A width of the n-type well 322 as measured between the source 382 and the depletion region 352 can be between 50 and 350 nanometers in some examples. A width of the depletion region 352 as measured between the n-type well 322 and the p-type layer 343 can be between 250 and 1,100 nanometers in some examples. A width of the p-type layer 343 as measured between the depletion region 352 and the isolation structure 333 (e.g., dielectric layer) can also be between 250 and 1,100 nanometers in some examples. A width of the p-type well 344 as measured between the isolation structure 333 and the isolation structure 334 can be between 400 and 600 nanometers in some examples. Similarly, the width of the n-type well 322 when measured between the isolation structure 332 and the depletion region 352 can also be between 400 and 600 nanometers in some examples. A width of the isolation structure 334 (and the isolation structure 333) as measured between the p-type well 334 and the p-type layer 343 can be between 250 and 1500 nanometers in some examples. These specific dimensions can provide advantages in terms of facilitating proper operation of the semiconductor device 300 with increased breakdown voltage characteristics.

## Claims

1. A semiconductor device (100, 200, 300), comprising:
a substrate (110, 210, 310) comprising a p-type well (142, 144, 242, 244, 342, 344, 346), an n-type well (122, 124, 126, 222, 224, 226, 322, 324), an n-type layer (121, 123, 125, 221, 223, 225, 321, 323), and a depletion region (152, 154, 252, 254, 352, 354);
a source (182, 184, 282, 284, 382, 384) disposed in the p-type well (142, 144, 242, 244, 342, 344, 346);
a drain (162, 164, 166, 262, 264, 266, 362, 364, 366) disposed in the n-type well (122, 124, 126, 222, 224, 226, 322, 324); and
a gate (172, 174, 272, 274, 372, 374) disposed over the p-type well (142, 144, 242, 244, 342, 344, 346), the depletion region (152, 154, 252, 254, 352, 354), and the n-type layer (121, 123, 125, 221, 223, 225, 321, 323);
wherein the depletion region (152, 154, 252, 254, 352, 354) and the n-type layer (121, 123, 125, 221, 223, 225, 321, 323) are disposed between the p-type well (142, 144, 242, 244, 342, 344, 346) and the n-type well (122, 124, 126, 222, 224, 226, 322, 324); and
wherein the depletion region (152, 154, 252, 254, 352, 354) is disposed between the p-type well (142, 144, 242, 244, 342, 344, 346) and the n-type layer (121, 123, 125, 221, 223, 225, 321, 323).

2. The semiconductor device (100, 200, 300) of claim 1, wherein a width of the depletion region (152, 154, 252, 254, 352, 354) as measured between the p-type well (142, 144, 242, 244, 342, 344, 346) and the n-type layer (121, 123, 125, 221, 223, 225, 321, 323) is between 250 and 1,100 nanometers.

3. The semiconductor device (100, 200, 300) of claim 1 or 2, comprising a dielectric layer disposed between the n-type layer (121, 123, 125, 221, 223, 225, 321, 323) and the n-type well (122, 124, 126, 222, 224, 226, 322, 324).

4. The semiconductor device (100, 200, 300) of claim 3, wherein a width of the n-type layer (121, 123, 125, 221, 223, 225, 321, 323) as measured between the depletion region (152, 154, 252, 254, 352, 354) and the dielectric layer is between 250 and 1,100 nanometers.

5. The semiconductor device (100, 200, 300) of any of claims 1 to 4, wherein a width of the p-type well (142, 144, 242, 244, 342, 344, 346) as measured between the source (182, 184, 282, 284, 382, 384) and the depletion region (152, 154, 252, 254, 352, 354) is between 50 and 350 nanometers.

6. The semiconductor device (100, 200, 300) of any of claims 1 to 5, wherein the n-type layer (121, 123, 125, 221, 223, 225, 321, 323) is disposed under the n-type well (122, 124, 126, 222, 224, 226, 322, 324).

7. The semiconductor device (100, 200, 300) of claim 6, comprising a first p-type layer disposed under the n-type layer (121, 123, 125, 221, 223, 225, 321, 323) and a second p-type layer disposed under the p-type well (142, 144, 242, 244, 342, 344, 346);
in particular wherein the depletion region (152, 154, 252, 254, 352, 354) is disposed between the first p-type layer and the second p-type layer.

8. The semiconductor device (100, 200, 300) of any of claims 1 to 7, comprising a body disposed in the p-type well (142, 144, 242, 244, 342, 344, 346).

9. A semiconductor device (100, 200, 300), comprising:
a substrate (110, 210, 310) comprising an n-type well (122, 124, 126, 222, 224, 226, 322, 324), a p-type well (142, 144, 242, 244, 342, 344, 346), a p-type layer, and a depletion region (152, 154, 252, 254, 352, 354); and
a source (182, 184, 282, 284, 382, 384) disposed in the n-type well (122, 124, 126, 222, 224, 226, 322, 324);
a drain (162, 164, 166, 262, 264, 266, 362, 364, 366) disposed in the p-type well (142, 144, 242, 244, 342, 344, 346); and
a gate (172, 174, 272, 274, 372, 374) disposed over the n-type well (122, 124, 126, 222, 224, 226, 322, 324), the depletion region (152, 154, 252, 254, 352, 354), and the p-type layer;
wherein the depletion region (152, 154, 252, 254, 352, 354) and the p-type layer are disposed between the n-type well (122, 124, 126, 222, 224, 226, 322, 324) and the p-type well (142, 144, 242, 244, 342, 344, 346); and
wherein the depletion region (152, 154, 252, 254, 352, 354) is disposed between the n-type well (122, 124, 126, 222, 224, 226, 322, 324) and the p-type layer.

10. The semiconductor device (100, 200, 300) of claim 9, comprising at least one of the following features:
(i) wherein a width of the depletion region (152, 154, 252, 254, 352, 354) as measured between the n-type well (122, 124, 126, 222, 224, 226, 322, 324) and the p-type layer is between 250 and 1,100 nanometers;
(ii) comprising a dielectric layer disposed between the p-type layer and the p-type well (142, 144, 242, 244, 342, 344, 346), wherein a width of the p-type layer as measured between the depletion region (152, 154, 252, 254, 352, 354) and the dielectric layer is between 250 and 1,100 nanometers;
(iii) wherein a width of the n-type well (122, 124, 126, 222, 224, 226, 322, 324) as measured between the source (182, 184, 282, 284, 382, 384) and the depletion region (152, 154, 252, 254, 352, 354) is between 50 and 350 nanometers;
(iv) wherein:
the p-type layer is disposed under the p-type well (142, 144, 242, 244, 342, 344, 346);
the semiconductor device (100, 200, 300) comprises an n-type layer (121, 123, 125, 221, 223, 225, 321, 323) disposed under the n-type well (122, 124, 126, 222, 224, 226, 322, 324); and
the depletion region (152, 154, 252, 254, 352, 354) is disposed between the n-type layer (121, 123, 125, 221, 223, 225, 321, 323) and the p-type layer.

11. A semiconductor device (100, 200, 300), comprising:
a substrate (110, 210, 310) comprising a p-type well (142, 144, 242, 244, 342, 344, 346), an n-type well (122, 124, 126, 222, 224, 226, 322, 324), an n-type layer (121, 123, 125, 221, 223, 225, 321, 323), and a depletion region (152, 154, 252, 254, 352, 354); and
a gate (172, 174, 272, 274, 372, 374) disposed over the p-type well (142, 144, 242, 244, 342, 344, 346), the depletion region (152, 154, 252, 254, 352, 354), and the n-type layer (121, 123, 125, 221, 223, 225, 321, 323);
wherein the depletion region (152, 154, 252, 254, 352, 354) and the n-type layer (121, 123, 125, 221, 223, 225, 321, 323) are disposed between the p-type well (142, 144, 242, 244, 342, 344, 346) and the n-type well (122, 124, 126, 222, 224, 226, 322, 324); and
wherein the depletion region (152, 154, 252, 254, 352, 354) is disposed between the p-type well (142, 144, 242, 244, 342, 344, 346) and the n-type layer (121, 123, 125, 221, 223, 225, 321, 323).

12. The semiconductor device (100, 200, 300) of claim 11, wherein a width of the depletion region (152, 154, 252, 254, 352, 354) as measured between the p-type well (142, 144, 242, 244, 342, 344, 346) and the n-type layer (121, 123, 125, 221, 223, 225, 321, 323) is between 250 and 1,100 nanometers.

13. The semiconductor device (100, 200, 300) of claim 11 or 12, comprising:
a drain (162, 164, 166, 262, 264, 266, 362, 364, 366) disposed in the n-type well (122, 124, 126, 222, 224, 226, 322, 324);
a body disposed in the p-type well (142, 144, 242, 244, 342, 344, 346); and
a source (182, 184, 282, 284, 382, 384) disposed in the p-type well (142, 144, 242, 244, 342, 344, 346);
in particular wherein a width of the p-type well (142, 144, 242, 244, 342, 344, 346) as measured between the source (182, 184, 282, 284, 382, 384) and the depletion region (152, 154, 252, 254, 352, 354) is between 250 and 1500 nanometers.

14. The semiconductor device (100, 200, 300) of any of claims 11 to 13, comprising a dielectric layer disposed between the n-type layer (121, 123, 125, 221, 223, 225, 321, 323) and the n-type well (122, 124, 126, 222, 224, 226, 322, 324), wherein a width of the n-type layer (121, 123, 125, 221, 223, 225, 321, 323) as measured between the depletion region (152, 154, 252, 254, 352, 354) and the dielectric layer is between 250 and 1,100 nanometers.

15. The semiconductor device (100, 200, 300) of any of claims 11 to 14, wherein:
the n-type layer (121, 123, 125, 221, 223, 225, 321, 323) is disposed under the n-type well (122, 124, 126, 222, 224, 226, 322, 324);
the semiconductor device (100, 200, 300) comprises a p-type layer disposed under the n-type layer (121, 123, 125, 221, 223, 225, 321, 323);
the semiconductor device (100, 200, 300) comprises a second n-type well (122, 124, 126, 222, 224, 226, 322, 324);
the semiconductor device (100, 200, 300) comprises a second n-type layer (121, 123, 125, 221, 223, 225, 321, 323) disposed under the second n-type well (122, 124, 126, 222, 224, 226, 322, 324);
the p-type well (142, 144, 242, 244, 342, 344, 346) is disposed between the second n-type well (122, 124, 126, 222, 224, 226, 322, 324) and the depletion region (152, 154, 252, 254, 352, 354); and
the depletion region (152, 154, 252, 254, 352, 354) is disposed between the second n-type layer (121, 123, 125, 221, 223, 225, 321, 323) and the p-type layer.
